Europäisches Patentamt

European Patent Office

Office européen des brevets

(11) Veröffentlichungsnummer: **0 365 859 B1**

(12) # EUROPÄISCHE PATENTSCHRIFT

(45) Veröffentlichungstag der Patentschrift: **11.05.94**

(51) Int. Cl.⁵: **H03H 17/02**

(21) Anmeldenummer: **89117892.3**

(22) Anmeldetag: **27.09.89**

(54) **Filter zur Gewinnung eines zeitlich konstanten Nutzsignals aus einem verrauschten Messsignal.**

(30) Priorität: **22.10.88 DE 3836115**

(43) Veröffentlichungstag der Anmeldung:
**02.05.90 Patentblatt 90/18**

(45) Bekanntmachung des Hinweises auf die
Patenterteilung:
**11.05.94 Patentblatt 94/19**

(84) Benannte Vertragsstaaten:
**BE CH DE FR GB LI NL SE**

(56) Entgegenhaltungen:
**US-A- 3 953 793**

**REVIEW OF SCIENTIFIC INSTRUMENTS. vol. 57, no. 11, November 1986, NEW YORK US-Seiten 2862 - 2869; W.S. COOPER: "Use of optimal estimation theory,inparticular the Kalman filter, in data analysis and signal processing"**

(73) Patentinhaber: **Bodenseewerk Gerätetechnik GmbH**
**Alte Nussdorfer Strasse 15**
**Postfach 1120**
**D-88662 Überlingen(DE)**

(72) Erfinder: **Krogmann, Uwe**
**Zur Äsche 24**
**D-7770 Überlingen/Nussdorf(DE)**

(74) Vertreter: **Weisse, Jürgen, Dipl.-Phys. et al**
**Patentanwälte Dipl.-Phys. Jürgen Weisse**
**Dipl.-Chem. Dr. Rudolf Wolgast**
**Bökenbusch 41**
**Postfach 11 03 86**
**D-42531 Velbert (DE)**

**Beschreibung**

**Technisches Gebiet**

Die Erfindung betrifft ein Filter zur Gewinnung eines zeitlich konstanten Nutzsignals aus einem verrauschten Meßsignal mit Mitteln zum Integrieren des Meßsignals.

In der Meßtechnik besteht häufig das Problem, ein konstantes Nutzsignal aus einem stark verrauschten Meßsignal herauszufiltern. Das Meßsignal enthält dabei neben weißem Rauschen häufig auch noch harmonische Komponenten. Weiterhin hat das Rauschen manchmal sehr niederfrequente Komponenten. Die zur Verfügung stehende Meßzeit ist in vielen Fällen relativ kurz.

Zur Gewinnung der Nutzinformation sind als klassische Filterverfahren Tiefpässe mit konstanten Koeffizienten bekannt. Diese bringen aber bei sehr niederfrequentem Rauschen und kurzer Meßzeit keine brauchbare Filterung.

In dem Buch von A. Gelb "Applied Optimal Estimation" Seiten 124 bis 126 ist ein Optimalfilter beschrieben, bei welchem die Differenz des Meßsignals und eines Schätzwertes des Meßsignals mit einem nach einer bestimmten Funktion der Zeit veränderlichen Faktor integriert wird, wobei das Integral den besagten Schätzwert des Meßsignals liefert. Eine solche Art der Filterung liefert gegenüber den klassischen Filterverfahren verbesserte Ergebnisse.

Die DE-B-24 41 926 beschreibt ein Verfahren zur Bestimmung von durch Störung beeinflußten Signalen, bei welchem die Signale integriert und der während einer bestimmten Integrationszeit erhaltene Integrationswert durch die Integrationszeit dividiert und angezeigt oder anderweitig weiterverarbeitet wird. Die Integrationszeit wird abhängig gemacht von einer Stabilisierung des angezeigten Wertes.

Die DE-A-30 40 753 beschreibt ein Verfahren zur Bestimmung einer mit einer störenden Wechselspannung überlagerten Gleichspannung, bei welchem die zu bestimmende Spannung aufintegriert wird. Die Integration erfolgt dabei zwischen definierten Phasenlagen der störenden Wechselspannung.

Ein Aufsatz von Cooper "Use of optimal estimation theory, in particular the Kalman filter, in data analysis ,and signal processing" in "Rev.Sci.Instrum." 57 (11), (1986), 2862-2869 beschreibt generell die Anwendung von Kalman-Filtern und gibt hierfür verschiedene Beispiele an.

Der Erfindung liegt die Aufgabe zugrunde, eine weiter verbesserte Filterung von verrauschten Meßsignalen zu erreichen. Insbesondere sollen auch niederfrequentes Rauschen und harmonische Störungen herausgefiltert werden. Die Meßzeit soll dabei möglichst verkürzt werden.

Erfindungsgemäß wird diese Aufgabe mit einem Filter der eingangs genannten Art dadurch gelöst, daß es einen Optimalschätzer umfaßt, der ein Modell des integrierten Meßsignals generiert, das einen konstanten Koeffizienten nullter Ordnung aufweist, der einen von harmonischen Komponenten im Meßsignal herrührenden konstanten Anteil repräsentiert, wobei der Optimalschätzer von der Differenz des integrierten Meßsignals und einem sich aus dem Modell ergebenden Schätzwert des integrierten Meßsignals beaufschlagt ist und zum Schätzen des einem linearen Signalanstieg entsprechenden Koeffizienten des Modells vorgesehen ist, der das gesuchte konstante Meßsignal repräsentiert.

Durch die Integration wird der konstante Anteil des Meßsignals, der das eigentliche Nutzsignal darstellt, gegenüber dem höherfrequenten Rauschen verstärkt. Die Amplitude harmonischer Komponenten wird reduziert. Bei der Integration einer harmonischen Komponente ergibt sich jedoch in der Regel ein konstanter Anteil am integrierten Signal, der von der Phase der harmonischen Komponente relativ zum Integrationsintervall abhängt. Die Integration erfolgt im allgemeinen nicht über eine ganze Anzahl von vollen Wellen.

In dem Modell des integrierten Meßsignals ist daher ein konstanter Koeffizient nullter Ordnung vorgesehen, der einen von harmonischen Komponenten herrührenden konstanten Anteil repräsentiert. Ein Koeffizient erster Ordnung repräsentiert das gesuchte konstante Nutzsignal, das bei der Integration zu einer Rampe des Schätzwertes führt.

Weiterhin enthält das Modell das Meßrauschen. Hinsichtlich des Meßrauschens bestehen keine bestimmten Voraussetzungen wie Mittelwertfreiheit mit Gauß - Verteilung. Ein Mittelwert des Meßrauschens würde durch den Koeffizienten erster Ordnung mit berücksichtigt.

Ausgestaltungen der Erfindung sind Gegenstand der Unteransprüche.

Ein Ausführungsbeispiel der Erfindung ist nachstehend unter Bezugnahme auf die zugehörigen Zeichnungen näher erläutert.

**Kurze Beschreiubung der Zeichnungen**

Fig.1    veranschaulicht das Signalprozeßmodell.

Fig.2    zeigt das Signalprozeßmodell nach Integration.

Fig.3    ist ein Blockdiagramm des Signalprozesses und der Signalverarbeitung in dem Filter.

Fig.4    zeigt eine Art der Realisierung der Signalverarbeitung mit einem zeitdiskreten Filter.

Fig.5    veranschaulicht die Erzeugung der zeitvariablen Filterparameter.

Fig.6    zeigt eine alternative Realisierung des Filters.

Fig.7    zeigt in doppelt - logarithmischer Darstellung den Einfluß einer Integration auf die Amplitude eines Signals.

Fig.8    zeigt ein erweitertes Signalprozeßmodell nach der Integration, ähnlich Fig.2, das für sehr niederfrequentes Rauschen eine zusätzliche Rampe im Meßsignal berücksichtigt.

Fig.9    zeigt eine dritte Art der Realisierung des Filters mit einem zeitdiskreten Filter nach Art von Fig.4, bei welchem das Signalprozeßmodell nach Fig.8 zugrundegelegt ist.

Fig.10   veranschaulicht die Erzeugung der zeitvariablen Filterparameter in einer Darstellung ähnlich Fig.5 für das Filter von Fig.8.

## Bevorzugte Ausführungen der Erfindung

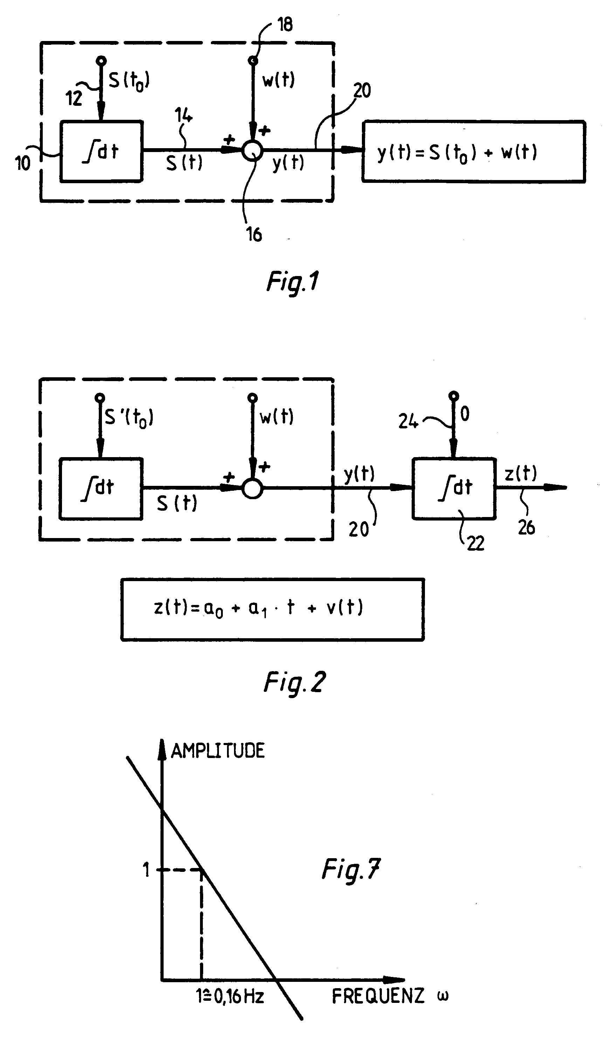

In Fig.1 ist das Signalprozeßmodell für ein konstantes Nutzsignal $S(t_o)$ dargestellt. Das konstante Nutzsignal ist symbolisiert durch einen Integrator 10 (als Speicher), auf den als Anfangswert auf einen Eingang 12 das konstante Nutzsignal $S(t_o)$ aufgeschaltet ist. Der Integrator 10 liefert dieses konstante Signal als Ausgangssignal $S(t)$ an einem Ausgang 14. In einem Summationspunkt 16 ist zu dem Nutzsignal das Rauschen $w(t)$ überlagert, das an einem Eingang 18 anliegt. Es ergibt sich ein Meßsignal $y(t)$ an einem Ausgang 20. Es ist

$$y(t) = S(t_o) + w(t).$$

Fig.2 zeigt demgegenüber das Signalprozeßmodell für das integrierte Meßsignal. Das Meßsignal $y(t)$ ergibt sich auf die gleiche Weise, wie unter Bezugnahme auf Fig.1 dargestellt ist. Das Meßsignal $y(t)$ vom Ausgang 20 ist auf einen Integrator 22 geschaltet. Als Anfangswert ist an einem Eingang 24 des Integrators 22 der Wert "0" vorgegeben. An einem Ausgang 26 des Integrators 22 ergibt sich das integrierte Meßsignal

$$z(t) = a_o + a_1 t + v(t).$$

Das integrierte Meßsignal $z(t)$ enthält einen konstanten Term $a_o$, also einen Koeffizienten nullter Ordnung. Dieser konstante Term berücksichtigt beispielsweise, daß die Integration eines harmonischen Signals je nach Phasenlage einen konstanten Rest ergibt. Er berücksichtigt auch einen eventuell endlichen Mittelwert des Rauschens. Der Koeffizient erster Ordnung $a_1$ repräsentiert das konstante Nutzsignal. Durch die Integration wird das Nutzsignal verstärkt. Der Einfluß harmonischer Komponenten im Meßsignal wird reduziert bis auf den konstanten Term $a_o$. Rauschanteile werden unterdrückt.

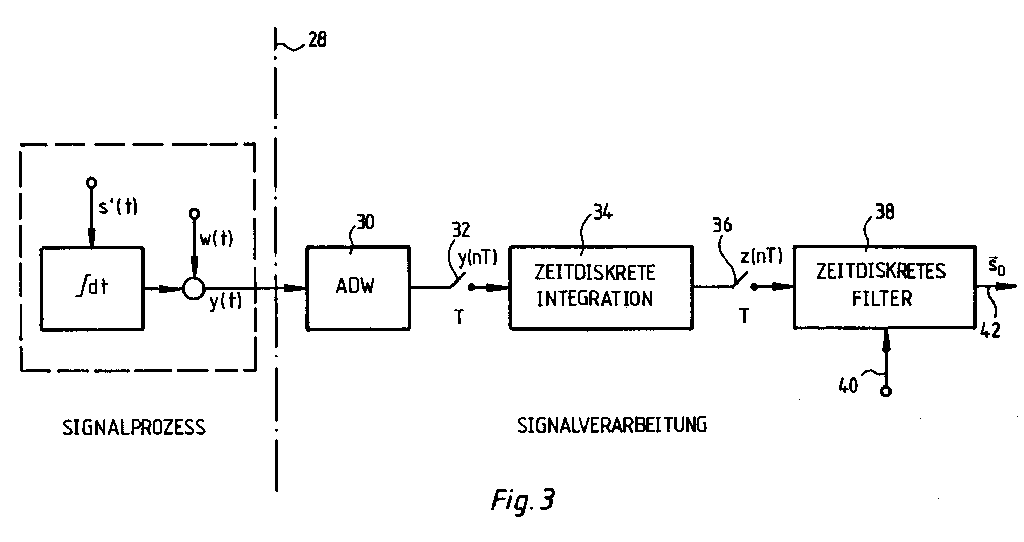

Fig.3 zeigt die allgemeine Struktur der Signalverarbeitung. Das Signalprozeßmodell ist links von der strichpunktierten Linie 28 dargestellt und entspricht Fig.1. Das Meßsignal $y(t)$ wird durch einen Analog - Digital - Wandler 30 in ein digitales Signal umgesetzt. Das Signal wird mit einem Takt T abgetastet und, wie durch Schalter 32 angedeutet ist, als Signal $y(nT)$ einer zeitdiskreten Integration unterworfen. Diese zeitdiskrete Integration ist durch den Block 34 dargestellt. Hierbei ist "n" die laufende Zahl des Taktes. "T" ist das Taktintervall. Die zeitdiskrete Integration gemäß Block 34 ergibt entsprechend das integrierte Meßsignal $z(nT)$, ebenfalls in einem Takt mit dem Taktintervall T, wie in Fig.3 durch den Schalter 36 angedeutet ist. Das integrierte Meßsignal $z(nT)$ beaufschlagt ein zeitdiskretes Filter 38. Dem zeitdiskreten Filter 38 wird Information über die Meßgenauigkeit zugeführt, was durch einen Eingang 40 dargestellt ist. Es liefert einen Schätzwert $S_o$ für das konstante Nutzsignal $S(t_o)$ an einem Ausgang 42.

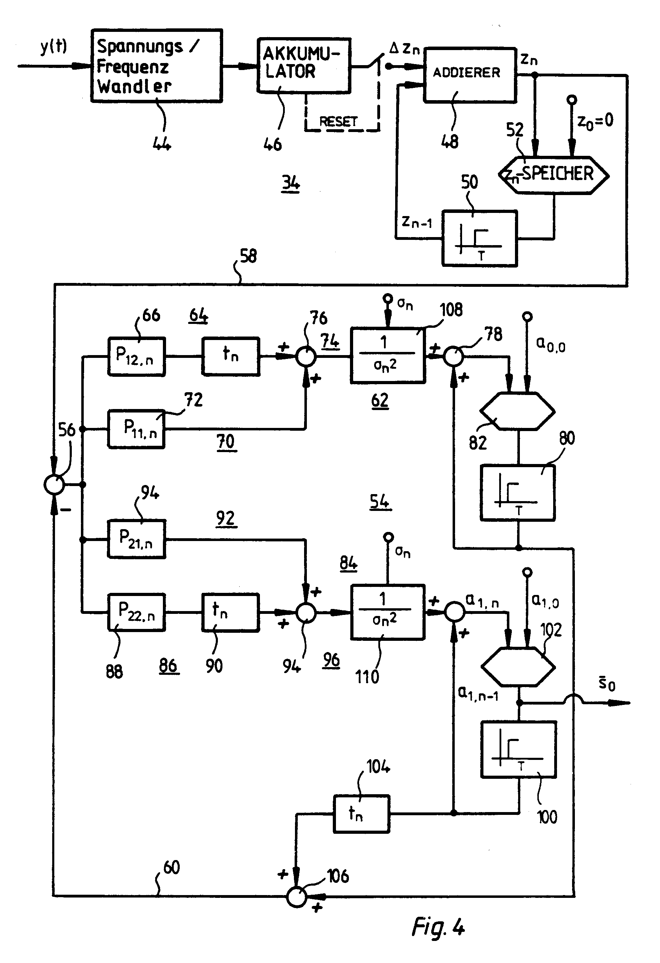

Fig.4 zeigt ein Ausführungsbeispiel für die Signalverarbeitung.

Die Mittel zum Integrieren des Meßsignals $y(t)$ enthalten einen Spannungs - Frequenz - Wandler 44. Der Spannungs - Frequenz - Wandler 44 setzt das Meßsignal $y(t)$ in eine dazu proportionale Frequenz um, wobei diese Frequenz groß gegen die Taktfrequenz ist. Ein rücksetzbarer Akkumulator 46 ist von den Ausgangssignalen des Spannungs - Frequenz - Wandlers 44 beaufschlagt und in einem vorgegebenen Takt, nämlich in zeitlichen Abständen T, rücksetzbar. Addiermittel 48 sind in dem besagten vorgegebenen Takt von dem Inhalt z des Akkumulators 46 als einem Summanden und mit einer Verzögerung von einem Takt, dargestellt durch Block 50, von dem Inhalt eines Speichers 52 beaufschlagt. In den Speicher 52 ist der Ausgang $z_n$ der Addiermittel 48 einlesbar. Der Ausgang $z_n$ der Addiermittel 48 liefert digital das Integral des Meßsignals.

Das zeitdiskrete Filter 38 (Fig.3) enthält einen Optimalschätzer 54. Dem Optimalschätzer 54 erhält in einem Summierpunkt 56 den Ausgang $z_n$ der Addiermittel 48, wie durch Linie 58 dargestellt ist. Weiterhin ist auf den Summierpunkt 56 der Schätzwert des integrierten Meßsignals aufgeschaltet. Das ist durch Linie 60 dargestellt. Dieser Schätzwert wird in noch zu beschreibender Weise gewonnen.

Der Optimalschätzer 54 enthält einen ersten Kanal 62. Der erste Kanal 62 weist Mittel 64 zum Multiplizieren der im Summierpunkt 56 gebildeten Differenz von integriertem Meßsignal $z_n$ und Schätzwert des integrierten Meßsignals mit einem ersten zeitvarianten Faktor $P_{12;n}$, dargestellt durch Block 66, und dem Zeitpunkt $t_n$ ($=nT$) des betreffenden Taktes, dargestellt durch Block 68, auf. Weiterhin enthält der erste Kanal 64 Mittel 70 zum Multiplizieren der Differenz von integriertem Meßsignal und Schätzwert des integrierten Meßsignals mit einem zweiten zeitvarianten Faktor $P_{11;n}$, dargestellt durch Block 72. Es sind Mittel 74 zum Addieren der so erhaltenen zwei Produkte, wie durch einen Summierpunkt 76 dargestellt ist, und Bilden eines eine Veränderung eines nullten Koeffizienten $a_o$ darstellenden Veränderungssignals vorgesehen. Nullte Addiermittel 78 sind von dem so erhaltenen Veränderungssignal als einem Summanden und mit Verzögerung von einem Takt, dargestellt durch Block 80, von dem Inhalt $a_{o,n-1}$ eines zweiten Speichers 82 als anderem Summanden beaufschlagt. Dabei ist in den Speicher 82 der Ausgang $a_{o,n}$ der nullten Addiermittel 78 einlesbar. Der durch Block 80 um einen Takt verzögerte Inhalt des zweiten Speichers 82, also $a_{o,n-1}$, bildet den nullten Koeffizienten des Modells.

Der Optimalschätzer 54 enthält einen zweiten Kanal 84. Der Kanal 84 weist Mittel 86 zum Multiplizieren der Differenz von integriertem Meßsignal und Schätzwert des integrierten Meßsignals mit einem dritten zeitvarianten Faktor $P_{22;n}$, dargestellt durch Block 88, und dem Zeitpunkt $t_n$ des betreffenden Taktes, dargestellt durch Block 90, auf. Weiterhin sind in dem Kanal 84 Mittel 92 zum Multiplizieren der Differenz von integriertem Meßsignal und Schätzwert des integrierten Meßsignals mit einem vierten zeitvarianten Faktor $P_{21,n}$, dargestellt durch Block 94, vorgesehen. Es sind Mittel 96 zum Addieren der so erhaltenen zwei Produkte und Bilden eines eine Veränderung eines ersten Koeffizienten darstellenden ersten Veränderungssignals vorgesehen. Die Summation der Produkte erfolgt in einem Summierpunkt 97. Ähnlich wie in dem ersten Kanal 62 sind erste Addiermittel 98 von dem so erhaltenen ersten Veränderungssignal als einem Summanden und mit Verzögerung von einem Takt, dargestellt durch Block 100, von dem Inhalt eines dritten Speichers 102 als anderem Summanden $a_{1;n-1}$ beaufschlagt. In den dritten Speicher 102 ist der Ausgang $a_{1;n}$ der ersten Addiermittel 98 einlesbar. Der um einen Takt verzögerte Inhalt des dritten Speichers 102 bildet den ersten Koeffizienten des Modells. Im zweiten Kanal 84 sind nun Mittel 104 zum Multiplizieren des besagten ersten Koeffizienten mit dem Zeitpunkt $t_n$ des betreffenden Taktes vorgesehen.

Es sind Mittel, dargestellt durch den Summierpunkt 106, zum Addieren des nullten Koeffizienten und des mit dem Zeitpunkt $t_n$ des Taktes multiplizierten ersten Koeffizienten zur Bildung eines Schätzwertes der Meßgröße vorgesehen. Der besagte erste Koeffizient liefert dabei einen Schätzwert für das konstante Nutzsignal.

Die Mittel 74 zum Bilden des nullten Veränderungssignals und die Mittel 96 zum Bilden des ersten Veränderungssignals können jeweils Mittel 108 bzw. 110 zum Dividieren der von den Addiermittel 76 erhaltenen Summe durch die Varianz des Meßrauschens enthalten. Es kann aber auch ein Gewichtssignal zugeführt werden, wie es beispielsweise in der gleichzeitig eingereichten Patentanmeldung "Filteranordnung zur Erzeugung eines Schätzwertes einer durch Störungen beeinflußten Meßgröße" beschrieben ist.

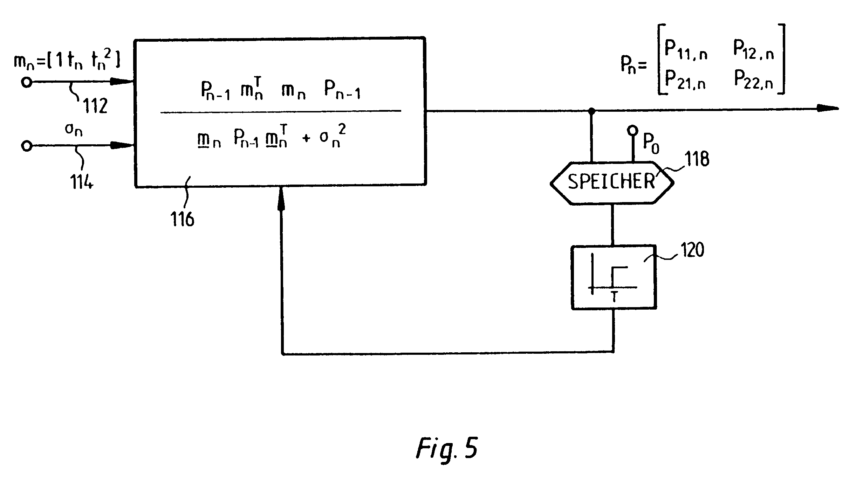

In Fig.5 ist die Erzeugung der zeitvariablen Filterparameter dargestellt. Auf einen Eingang 112 wird ein Vektor

$$\underline{m}_n = [\, 1 \;\; t_n \,]$$

gegeben. An einem Eingang 114 wird die Varianz des Rauschens eingegeben. Daraus wird rekursiv die Matrix $P_n$ der Filterparameter nach der Beziehung

$$\frac{P_{n-1}\, \underline{m}_n^T\, \underline{m}_n\, P_{n-1}}{\underline{m}_n\, P_{n-1}\, \underline{m}_n^T + \sigma_n^2}$$

gebildet. Das ist durch Block 116 dargestellt. Die so gebildete Matrix $P_n$ wird in einem Speicher 118 gespeichert und steht mit einer Verzögerung von einem Takt, dargestellt durch Block 120 für die rekursive Bildung des nächsten Wertes der Matrix gemäß Block 116 zur Verfügung. Die so jeweils rekursiv gebildete Matrix ist auf das Optimalfilter 54 (Fig.4) aufgeschaltet und bestimmt dort die durch die Blöcke 66,72,88 und 94 dargestellten Faktoren.

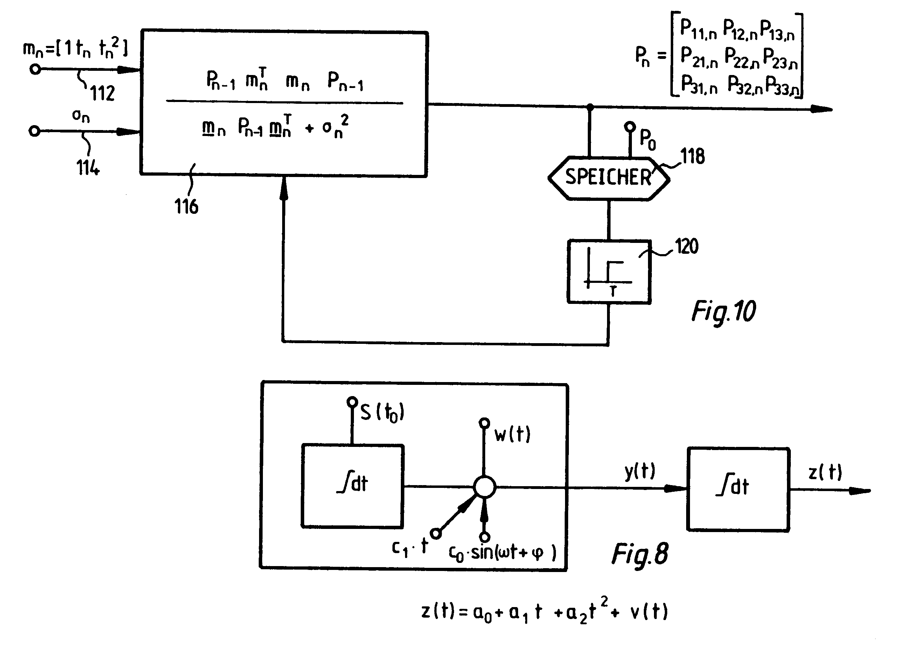

Eine weitere Ausgestaltung des beschriebenen Filters ist nachstehend anhand der Figuren 7 bis 10 beschrieben.

In Fig.7 ist in doppelt logarithmischer Darstellung der Einfluß der Integration auf die Amplitude einer harmonischen Komponente des Meßsignals in Abhängigkeit von der Kreisfrequenz, also gewissermaßen der frequenzabhängige Verstärkungsgrad des Integrators, dargestellt. Man erkennt, daß dieser "Verstärkungsgrad" unterhalb einer Kreisfrequenz von 1, also einer Frequenz von 0,16 Hertz, größer als 1 wird. Sehr niederfrequentes Rauschen würde daher durch die Integration verstärkt. Um dieser Verstärkung sehr niederfrequenten Rauschens Rechnung zu tragen, wird bei der Ausführung des Filters nach Fig. 8 bis 10 das Signalpro-

zessmodell durch eine Rampenfunktion $c_1$ t ergänzt. Das ist in Fig.8 dargestellt. Diese Rampenfunktion entspricht einer langsamen Änderung des Meßsignals und nähert damit sehr niederfrequentes Rauschen an.

Durch die Integration ergibt sich dann als integriertes Meßsignal

$$z(t) = a_o + a_1 t + a_2 t^2 + v(t).$$

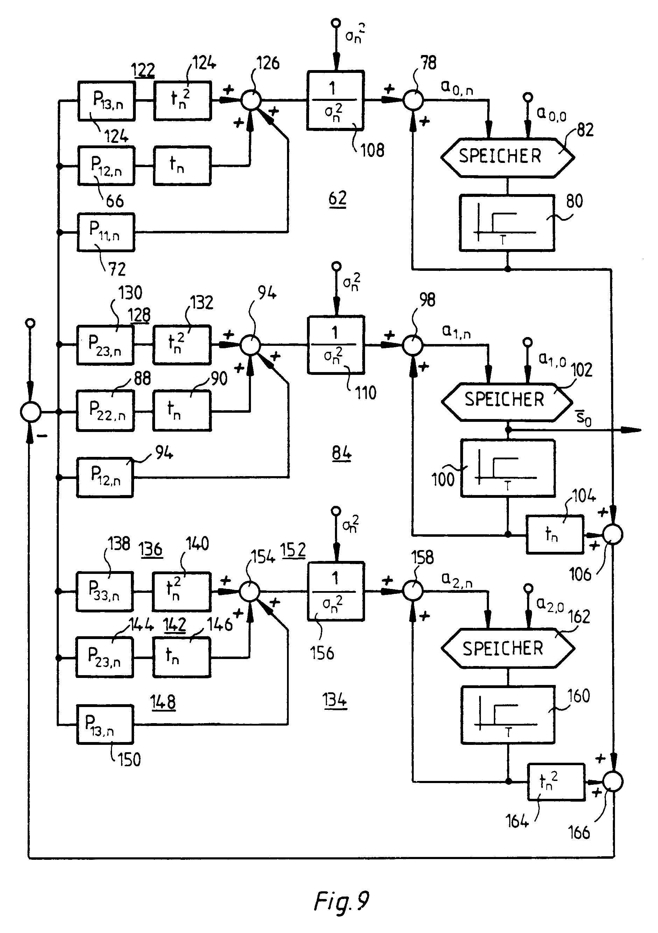

Dieses Signalprozeßmodell ist dem Optimalfilter von Fig.9 zugrunde gelegt. Im übrigen sind in Fig.8 und 9 entsprechende Teile mit den gleichen Bezugszeichen versehen wie in Fig.2 und 4.

Gegenüber dem Optimalfilter von Fig.4 enthält der erste Kanal 62 zusätzlich Mittel 122 zum Multiplizieren der Differenz von integriertem Meßsignal und Schätzwert des integrierten Meßsignals mit einem fünften zeitvarianten Faktor $P_{13,n}$, dargestellt durch Block 124, und dem Quadrat des Zeitpunktes $t_n^2$ des betreffenden Taktes, dargestellt durch Block 126. Das Produkt beaufschlagt ebenfalls die Mittel 74 zum Bilden des eine Veränderung des nullten Koeffizienten darstellenden Veränderungssignals. Weiterhin enthält der zweite Kanal 96 zusätzlich Mittel 128 zum Multiplizieren der Differenz von integriertem Meßsignal und Schätzwert des integrierten Meßsignals mit einem sechsten zeitvarianten Faktor $P_{23;n}$, dargestellt durch Block 130 und dem Quadrat des Zeitpunktes $t_n^2$ des betreffenden Taktes, dargestellt durch Block 132. Das Produkt beaufschlagt ebenfalls die Mittel 84 zum Bilden des eine Veränderung des ersten Koeffizienten darstellenden Veränderungssignals.

Schließlich enthält der Optimalschätzer 54 einen dritten Kanal 134. Der dritte Kanal 134 enthält Mittel 136 zum Multiplizieren der Differenz von integriertem Meßsignal und Schätzwert des integrierten Meßsignals mit einem siebenten zeitvarianten Faktor $P_{33;n}$, dargestellt durch Block 138 und dem Quadrat des Zeitpunktes $t_n^2$ des betreffenden Taktes, dargestellt durch Block 140. Weiterhin enthält der dritte Kanal 134 Mittel 142 zum Multiplizieren der Differenz von integriertem Meßsignal und Schätzwert des integrierten Meßsignals mit einem achten zeitvarianten Faktor $P_{23;n}$, dargestellt durch Block 144, und dem Zeitpunkt $t_n$ des betreffenden Taktes, dargestellt durch Block 146. Der dritte Kanal 134 enthält ferner Mittel 148 zum Multiplizieren der Differenz von integriertem Meßsignal und Schätzwert des integrierten Meßsignals mit einem siebenten zeitvarianten Faktor $P_{13;n}$, dargestellt durch einen Block 150. Wie in den anderen Kanälen sind auch in dem dritten Kanal Mittel zum Addieren der so erhaltenen drei Produkte und Bilden eines eine Veränderung eines zweiten Koeffizienten darstellenden zweiten Veränderungssignals vorgesehen. Diese Mittel enthalten einen Summierpunkt 154 und Mittel 156 zur Division der erhaltenen Summe durch die Varianz des Meßrauschens.

Es sind ebenfalls wie in den anderen Kanälen 62 und 96 zweite Addiermittel 158 vorgesehen, die von dem so erhaltenen zweiten Veränderungssignal als einem Summanden und mit Verzögerung von einem Takt, dargestellt durch Block 160, von dem Inhalt eines vierten Speichers 162 als anderem Summanden beaufschlagt sind. In den vierten Speicher 162 ist der Ausgang der zweiten Addiermittel 158 einlesbar. Der um einen Takt verzögerte Inhalt des vierten Speichers 162 bildet den zweiten Koeffizienten $a_2$ des Modells.

Schließlich enthält der dritte Kanal 134 Mittel 164 zum Multiplizieren des besagten zweiten Koeffizienten $a_2$ mit dem Quadrat des Zeitpunktes $t_n^2$ des betreffenden Taktes.

In dem Summierpunkt 106 werden die Ausgänge des ersten und des zweiten Kanals 62 bzw. 84 addiert. In einem weiteren Summierpunkt 166 wird dann noch der Ausgang des dritten Kanals 134 hinzuaddiert. Dadurch ergibt sich ein Schätzwert des integrierten Meßsignals. Ein Schätzwert $S_o$ für das Nutzsignal wird an dem Speicher 82 abgenommen. Dieser Schätzwert entspricht dem ersten Koeffizienten.

Fig.10 veranschaulicht die Erzeugung der zeitvariablen Filterparameter. Das sind jetzt neun Filterparameter, die in einer Matrix $P_n$ zusammengefaßt sind. Die Matrix $P_n$ enthält bei der Ausführung nach Fig.9 und 10 drei Zeilen und drei Spalten. In Fig.9 sind die Elemente der Matrix $P_n$ durch die Blöcke 72,66,124;94,88,130;150,144,138 dargestellt.

Die Erzeugung der Filterparameter erfolgt in der gleichen Weise wie bei der Ausführung von Fig.5. Entsprechende Elemente sind in Fig.10 mit den gleichen Bezugszeichen versehen wie dort. Allerdings enthält der Vektor $\underline{m}_n$ hier drei Komponenten

$$\underline{m}_n = [1 \ t_n \ t_n^2],$$

und die Matrizen haben alle drei Zeilen und drei Spalten.

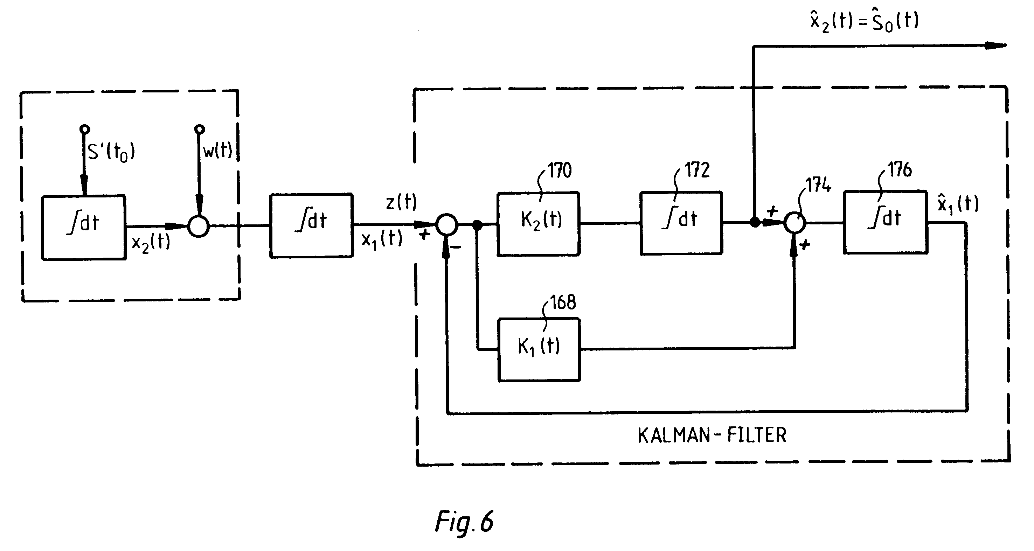

Fig.6 zeigt eine andere Ausführungsform des Optimalfilters.

Das Optimalfilter ist ein Kalman - Filter. Die Differenz von integriertem Meßsignal und Schätzwert des integrierten Meßsignals wird mit einer ersten zeitvariablen Funktion $K_1(t)$, dargestellt durch einen Block 168, multipliziert. Weiterhin wird die Differenz von integriertem Meßsignal und Schätzwert des integrierten Meßsignals mit einer zweiten zeitvariablen Funktion $K_2(t)$, dargestellt durch einen Block 170 multipliziert und durch erste integrierende Mittel 172 zeitlich integriert. Durch Addiermittel 174 werden die so gebildeten Größen addiert. Durch zweite integrierende Mittel 176 wird die so gebildete Summe zur Bildung des besagten Schätzwertes des integrierten Meßsignals integriert. Dabei liefert der Ausgang der ersten integrierenden Mittel 172 den Schätzwert des Nutzsignals liefert.

Im übrigen sind das Signalprozeßmodell und die Integration des Meßsignals genau so wie in Fig.2. Entsprechende Elemente tragen die gleichen Bezugszeichen wie dort.

Ein Filter der beschriebenen Art kann beispielsweise bei einem bandaufgehängten, gefesselten Meridiankreisel zur Filterung der den Winkel zwischen Gerätereferenz und Nord angebenden Fesselsignale benutzt werden. Ein solcher Meridiankreisel mit einem Filter, das nach Art des vorstehend beschriebenen Filters aufgebaut sein kann, ist in der gleichzeitig eingereichten Patentanmeldung "Filteranordnung zur Erzeugung eines Schätzwertes einer durch Störungen beeinflußten Meßgröße" beschrieben.

Bei dieser Anwendung kann als Anfangswert $a_{1;0}$ für den Koeffizienten ein Wert angesetzt werden, der sich aus einer üblichen Vorausrichtung des Meridiankreisels ergibt. Dieser Wert wird in den Speicher 102 eingegeben. Über die Anfangswerte der anderen Koeffizienten ist nichts bekannt. Diese Anfangswerte werden zweckmäßigerweise in die Speicher 82 und 162 eingegeben. Bei der Erzeugung der Filterparameter $P_{i;k}$ wird in den Speicher 118 eine Matrix $P_o$ eingegeben. Das ist eine Diagonalmatrix in deren Diagonale die Varianzen in der Kenntnis der Anfangswerte der Koeffizienten $a_{o,o}$, $a_{1,0}$ und $a_{2,0}$ stehen. Keines dieser Diagonalelemente darf null gesetzt werden. Es ist also:

$$
P_0 = \begin{bmatrix} \sigma_{a_0}^2 & 0 & 0 \\ 0 & \sigma_{a_1}^2 & 0 \\ 0 & 0 & \sigma_{a_2}^2 \end{bmatrix}
$$

## Patentansprüche

1. Filter zur Gewinnung eines zeitlich konstanten Nutzsignals aus einem verrauschten Meßsignal mit Mitteln (34) zum Integrieren des Meßsignals,
   **dadurch gekennzeichnet, dass**
   es einen Optimalschätzer (54) umfaßt, der ein Modell des integrierten Meßsignals generiert, das einen konstanten Koeffizienten nullter Ordnung aufweist, der einen von harmonischen Komponenten im Meßsignal herrührenden Anteil repräsentiert, wobei der Optimalschätzer (54) von der Differenz des integrierten Meßsignals und einem sich aus dem Modell ergebenden Schätzwert des integrierten Meßsignals beaufschlagt ist und zum Schätzen des einem linearen Signalanstieg entsprechenden Koeffizienten des Modells vorgesehen ist, der das gesuchte konstante Meßsignal repräsentiert.

2. Filter nach Anspruch 1, **dadurch gekennzeichnet, daß** es zeitdiskret arbeitet.

3. Filter nach Anspruch 2, **dadurch gekennzeichnet, daß** die Mittel zum Integrieren des Meßsignals
   (a) einen Spannungs - Frequenz - Wandler (44) enthalten sowie
   (b) einen rücksetzbaren Akkumulator (46), welcher von den Ausgangssignalen des Spannungs - Frequenz - Wandlers (44) beaufschlagt und in einem vorgegebenen Takt rücksetzbar ist,
   (c) Addiermittel (48), die in dem besagten vorgegebenen Takt von dem Inhalt des Akkumulators (46) als einem Summanden und mit einer Verzögerung von einem Takt von dem Inhalt eines Speichers (52) beaufschlagt ist,
   (d) in den Speicher (52) der Ausgang der Addiermittel (48) einlesbar ist, wobei der Ausgang der Addiermittel (48) digital das Integral des Meßsignals liefert.

4. Filter nach Anspruch 2 oder 3, **dadurch gekennzeichnet, daß**
   (a) der Optimalschätzer (54) einen ersten Kanal (62) enthält mit
   - Mitteln (64) zum Multiplizieren der Differenz von integriertem Meßsignal und Schätzwert des integrierten Meßsignals mit einem ersten zeitvarianten Faktor ($P_{12;n}$) und dem Zeitpunkt ($t_n$) des betreffenden Taktes,
   - Mitteln (72) zum Multiplizieren der Differenz von integriertem Meßsignal und Schätzwert des integrierten Meßsignals mit einem zweiten zeitvarianten ($P_{11;n}$) Faktor,
   - Mitteln (74) zum Addieren der so erhaltenen zwei Produkte und Bilden eines eine Veränderung eines nullten Koeffizienten ($a_o$) darstellenden Veränderungssignals und,
   - nullten Addiermitteln (78), die von dem so erhaltenen Veränderungssignal als einem Summanden und mit Verzögerung von einem Takt von dem Inhalt eines zweiten Speichers (82) als anderem Summanden beaufschlagt sind, wobei

- in den Speicher (82) der Ausgang der nullten Addiermittel (78) einlesbar ist und der Inhalt des zweiten Speichers (82) den nullten Koeffizienten des Modells bildet,

(b) der Optimalschätzer (54) einen zweiten Kanal (84) enthält mit

- Mitteln (86) zum Multiplizieren der Differenz von integriertem Meßsignal und Schätzwert des integrierten Meßsignals mit einem dritten zeitvarianten Faktor ($P_{22;n}$) und dem Zeitpunkt ($t_n$) des betreffenden Taktes,
- Mitteln (92) zum Multiplizieren der Differenz von integriertem Meßsignal und Schätzwert des integrierten Meßsignals mit einem vierten zeitvarianten Faktor ($P_{21;n}$),
- Mitteln (96) zum Addieren der so erhaltenen zwei Produkte und Bilden eines eine Veränderung eines ersten Koeffizienten ($a_1$) darstellenden ersten Veränderungssignals,
- ersten Addiermitteln (98), die von dem so erhaltenen ersten Veränderungssignal als einem Summanden und mit Verzögerung von einem Takt von dem Inhalt eines dritten Speichers (102) als anderem Summanden beaufschlagt sind, wobei
- in den Speicher (102) der Ausgang der ersten Addiermittel (98) einlesbar ist und der um einen Takt verzögerte Inhalt des dritten Speichers (102) den ersten Koeffizienten ($a_1$) des Modells bildet, und
- Mitteln (104) zum Multiplizieren des besagten ersten Koeffizienten ($a_1$) mit dem Zeitpunkt ($t_n$) des betreffenden Taktes,

(c) Mittel (106) zum Addieren des nullten Koeffizienten ($a_o$) und des mit dem Zeitpunkt ($t_n$) des Taktes multiplizierten ersten Koeffizienten ($a_1$) zur Bildung eines Schätzwertes der Meßgröße, wobei

(d) der besagte erste Koeffizient ($a_1$) einen Schätzwert für das konstante Nutzsignal liefert.

5. Filter nach Anspruch 4, **dadurch gekennzeichnet, daß** die Mittel (74) zum Bilden des nullten Veränderungssignals und die Mittel (96) zum Bilden des ersten Veränderungssignals jeweils Mittel (108,110) zum Dividieren der von den Addiermitteln (76,94) erhaltenen Summe durch die Varianz des Meßrauschens enthalten.

6. Filter nach Anspruch 4 oder 5, **dadurch gekennzeichnet, daß**

(a) der erste Kanal (62) zusätzlich Mittel (122) zum Multiplizieren der Differenz von integriertem Meßsignal und Schätzwert des integrierten Meßsignals mit einem fünften zeitvarianten Faktor ($P_{13;n}$) und dem Quadrat des Zeitpunktes ($t_n^2$) des betreffenden Taktes enthält und das Produkt ebenfalls die Mittel (74) zum Bilden des eine Veränderung des nullten Koeffizienten ($a_o$) darstellenden Veränderungssignals beaufschlagt,

(b) der zweite Kanal (84) zusätzlich Mittel (128) zum Multiplizieren der Differenz von integriertem Meßsignal und Schätzwert des integrierten Meßsignals mit einem sechsten zeitvarianten Faktor ($P_{23;n}$) und dem Quadrat des Zeitpunktes ($t_n^2$) des betreffenden Taktes enthält und das Produkt ebenfalls die Mittel (96) zum Bilden des eine Veränderung des ersten Koeffizienten ($a_1$) darstellenden Veränderungssignals beaufschlagt,

(c) der Optimalschätzer (54) einen dritten Kanal (134) enthält mit

- Mitteln (136) zum Multiplizieren der Differenz von integriertem Meßsignal und Schätzwert des integrierten Meßsignals mit einem siebenten zeitvarianten Faktor ($P_{33;n}$) und dem Quadrat des Zeitpunktes ($t_n^2$) des betreffenden Taktes,
- Mitteln (142) zum Multiplizieren der Differenz von integriertem Meßsignal und Schätzwert des integrierten Meßsignals mit einem achten zeitvarianten Faktor ($P_{23;n}$) und dem Zeitpunkt ($t_n$) des betreffenden Taktes,
- Mitteln (148) zum Multiplizieren der Differenz von integriertem Meßsignal und Schätzwert des integrierten Meßsignals mit einem neunten zeitvarianten Faktor ($P_{13;n}$),
- Mitteln (152) zum Addieren der so erhaltenen drei Produkte und Bilden eines eine Veränderung eines zweiten Koeffizienten ($a_2$) darstellenden zweiten Veränderungssignals,
- zweiten Addiermitteln (158), die von dem so erhaltenen zweiten Veränderungssignal als einem Summanden und mit Verzögerung von einem Takt von dem Inhalt eines vierten Speichers (162) als anderem Summanden beaufschlagt sind, wobei

- in den vierten Speicher (162) der Ausgang der zweiten Addiermittel (158) einlesbar ist und der um einen Takt verzögerte Inhalt des vierten Speichers (162) den zweiten Koeffizienten ($a_2$) des Modells bildet, und
- Mitteln (164) zum Multiplizieren des besagten zweiten Koeffizienten ($a_2$) mit dem Quadrat des Zeitpunktes ($t_n$) des betreffenden Taktes.

7. Filter nach Anspruch 1, **dadurch gekennzeichnet, daß** es als Kalman - Filter ausgebildet ist, bei welchem
   (a) die Differenz von integriertem Meßsignal und Schätzwert des integrierten Meßsignals mit einer ersten zeitvariablen Funktion ($K_1$-(t)) multipliziert wird und
   (b) die Differenz von integriertem Meßsignal und Schätzwert des integrierten Meßsignals mit einer zweiten zeitvariablen Funktion ($K_2$-(t)) multipliziert und durch erste integrierende Mittel (172) zeitlich integriert wird,
   (c) durch Addiermittel (174) die so gebildeten Größen addiert werden und
   (d) durch zweite integrierende Mittel (176) die so gebildete Summe zur Bildung des besagten Schätzwertes des integrierten Meßsignals integriert wird, wobei
   (e) der Ausgang der ersten integrierenden Mittel (172) den Schätzwert des Nutzsignals liefert.

## Claims

1. Filter for obtaining a useful signal which is constant with respect to time, from a noisy measuring signal using means (34) for integrating the measuring signal,
   **characterised in that**
   the filter comprises an optimal estimator (54) which generates a model of the integrated measuring signal having a constant zero order coefficient which represents a portion originating from harmonic components present in the measuring signal, said optimal estimator (54) having applied thereto the difference of the integrated measuring signal and an estimated value of the integrated measuring signal, which estimated value results from the model, and being provided for estimating a model coefficient which corresponds to a linear signal rise and which represents the desired constant measuring signal.

2. Filter according to claim 1, **characterised in that** the filter operates in discrete values in time.

3. Filter according to claim 2, **characterised in that** the means for integrating the measuring signal contain
   (a) a voltage-to-frequency converter (44) as well as
   (b) a resettable accumulator (46) having applied thereto the output signals from the voltage-to-frequency converter (44) and being resettable at a predetermined clock cycle,
   (c) adding means (48) having applied thereto the contents of the accumulator (46) at said predetermied clock cycle as one summand and the contents of a memory (52) at a delay of one clock cycle,
   (d) the output of the adding means (48) being readable into the memory (52) whereby the output of the adding means (48) digitally provides the integral of the measuring signal.

4. Filter according to claim 2 or 3, **characterised in that**
   (a) the optimal estimator (54) contains a first channel (62) including
   - means (64) for multiplying the difference of the integrated measuring signal and the estimated value of the integrated measuring signal by a first time-variant factor ($P_{12;n}$) and the moment of time ($t_n$) the respective clock cycle,
   - means (72) for multiplying the difference of the integrated measuring signal and the estimated value of the integrated measuring signal by a second time-variant factor ($P_{11;n}$),
   - means (74) for adding the thus obtained two products products and forming a variation signal representing a variation in the zero coefficient ($a_0$) and,
   - zero adding means (78) having applied thereto the thus obtained variation signal as one summand and the contents of a second memory (82) as an other summand at a delay of one clock cycle, whereby
   - the output of the zero adding means (78) is readable into the memory (82) and the contents of the second memory (82) forms the zero coefficient of the model,
   (b) the optimal estimator (54) contains a second channel (84) including
   - means (86) for multiplying the difference of the integrated measuring signal and the estimated value of the integrated measuring signal by a third time-variant factor ($P_{22;n}$) and the moment of time ($t_n$) of the respective clock cycle,

- means (92) for multiplying the difference of the integrated measuring signal and the estimated value of the integrated measuring signal by a fourth time-variant factor ($P_{21;n}$),
- means (96) for adding the thus obtained two products and forming first variation signal representing a variation in a first coefficient ($a_1$),
- first adding means (98) having applied thereto the thus obtained first variation signal as one summand and the contents of a third memory (102) as an other summand at a delay of one clock cycle, whereby
- the output of the first adding means (98) is readable into the memory (102) and the contents of the third memory (102), which is delayed by one clock cycle, forms the first coefficient ($a_1$) of the model, and
- means (104) for multiplying said first coefficient ($a_1$) by the time ($t_n$) of the respective clock cycle,

(c) means (106) for adding the zero coefficient ($a_0$) and the first coefficient ($a_1$) multiplied by the time ($t_n$) of the clock cycle for forming an estimated value of the measuring variable, whereby

(d) said first coefficient ($a_1$) providing an estimated value of the constant useful signal.

5. Filter according to claim 4, **characterised in that** the means (74) for forming the zero variation signal and the means (96) for forming the first variation signal each contain means (108,110) for dividing the sum obtained from the adding means (76,94) by the variance of the measuring noise.

6. Filter according to claim 4 or 5, **characterised in that**

(a) the first channel (62) additionally contains means (122) for multiplying the difference of the integrated measuring signal and the estimated value of the integrated measuring signal by a fifth time-variant factor ($P_{13;n}$) and the square of the time (($t_n$)$^2$) of the respective clock cycle and the product is also applied to the means (74) for forming the variation signal representing a variation in the zero coefficient ($a_0$),

(b) the second channel (84) additionally contains means (128) for multiplying the difference of the integrated measuring signal and the estimated value of the integrated measuring signal by a sixth time-variant factor ($P_{23;n}$) and the square of the time (($t_n$)$^2$) of the respective clock cycle and the product is also applied to the means (96) for forming the variation signal representing a variation in the first coefficient ($a_1$),

(c) the optimal estimator (54) contains a third channel (134) including

- means (136) for multiplying the difference of the integrated measuring signal and the estimated value of the integrated measuring signal by a seventh time-variant factor ($P_{33;n}$) and the sqare of the time (($t_n$)$^2$) of the respective clock cycle,
- means (142) for multiplying the difference of the integrated measuring signal and the estimated value of the integrated measuring signal by an eighth time-variant factor ($P_{23;n}$) and the time ($t_n$) of the respective clock cycle,
- means (148) for muultiplying the difference of the integrated measuring signal and the estimated value of the integrated measuring signal by a ninth time-variant factor ($P_{13;n}$),
- means (152) for adding the thus obtained three products and forming a second variation signal representing a variation in a second coefficient ($a_2$),
- second adding means (158) having applied thereto the thus obtained second variation signal as one summand and the contents of a fourth memory (162) as an other summand at a delay of one clock cycle, whereby
- the output of the second adding means (158) is readable into the fourth memory (162) and the contents of the fourth memory (162), which is delayed by one clock cycle, forms the second coefficient ($a_2$) of the model, and
- means (164) for multiplying said second coefficient ($a_2$) by the square of the time ($t_n$) of the respective clock cycle.

7. Filter according to claim 1, **characterised in that** the filter is constructed as a Kalman filter wherein

(a) the difference of the integrated measuring signal and the estimated value of the integrated measuring signal are multiplied by a first time-variable function ($K_1(t)$) and

(b) the difference of the integrated measuring signal and the estimated value of the integrated measuring signal is multiplied by a second time-variable function ($K_2(t)$) and integrated with respect to time by first integrating means (172),

(c) the thus formed magnitudes are added by adding means (174) and

(d) the thus obtained sum is integrated by second integrating means (176) for forming said estimated value of the integrated measuring signal, whereby

(e) the output of the first integrating means (172) provides the estimated value of the useful signal.

**Revendications**

1. Filtre destiné à l'obtention d'un signal utile constant dans le temps à partir d'un signal de mesure bruiteux avec des moyens (34) destinés à l'intégration du signal de mesure

     **caractérisé par le fait qu'**

il inclue un estimateur optimal (54) engendrant un modèle du signal de mesure intégré présentant un coefficient constant d'ordre zéro représentant une part provenant de composantes harmoniques dans le signal de mesure, la différence entre le signal de mesure intégré et une valeur estimative résultant du modèle du signal de mesure intégré étant appliquée à l'estimateur optimal (54) qui est prévu afin d'estimer le coefficient du modèle qui correspond à une montée linéaire de signal, coefficient qui représente le signal de mesure constant recherché.

2. Filtre selon la revendication 1, **caractérisé par le fait qu'**il opère à valeurs discrètes en temps.

3. Filtre selon la revendication 2, **caractérisé par le fait que** les moyens destinés à l'intégration du signal de mesure comprennent

(a) un convertisseur tension-fréquence (44), et

(b) un accumulateur (46) susceptible d'être remis et auquel les signaux de sortie du convertisseur tension-fréquence (44) sont appliqués et qui est susceptible d'être remis en cycle prédéterminé,

(c) des moyens d'addition (48) auxquels sont appliqués, dans ledit cycle prédéterminé, le contenu de l'accumulateur (46) comme un terme d'une somme, et, avec un retardement d'un cycle, le contenu d'une mémoire (52),

(d) la sortie des moyens d'addition (48) est susceptible d'être lue dans la mémoire (52), la sortie des moyens d'addition (48) fournissant digitalement l'intégral du signal de mesure.

4. Filtre selon la revendication 2 ou 3, **caractérisé par le fait que**

(a) l'estimateur optimal (54) comprend un premier canal (62), avec

  - des moyens (64) destinés à multiplier la différence entre le signal de mesure intégré et la valeur estimative du signal de mesure intégré par un premier facteur ($P_{12,n}$) variable en temps, et le temps ($t_n$) du cycle respectif,

  - des moyens (72) destinés à multiplier la différence entre le signal de mesure intégré et la valeur estimative du signal de mesure intégré par un second facteur ($P_{11;n}$) variable en temps,

  - des moyens (74) destinés à l'addition des deux produits ainsi obtenus et à la formation d'un signal de variation représentant une variation d'un coefficient zéro ($a_0$), et

  - des moyens d'addition zéro (78) auxquels sont appliqués le signal de variation ainsi obtenu comme un terme d'une somme, et, avec retardement d'un cycle, le contenu d'une seconde mémoire (82) comme l'autre terme de la somme,

  - la sortie des moyens d'addition zéro (78) étant susceptible d'être lue dans la mémoire (82), et le contenu de la seconde mémoire (82) formant le coefficient zéro du modèle,

(b) l'estimateur optimal (54) comprend un second canal (84) avec

  - des moyens (86) destinés à multiplier la différence entre le signal de mesure intégré et la valeur estimative du signal de mesure intégré par un troisième facteur ($P_{22,n}$) variable en temps, et le temps ($t_n$) du cycle respectif,

  - des moyens (92) destinés à multiplier la différence du signal de mesure intégré et la valeur estimative du signal de mesure intégré par un quatrième facteur ($P_{21;n}$) variable en temps,

  - des moyens (96) destinés à l'addition des deux produits ainsi obtenus et à la formation d'un signal de variation représentant une variation d'un pre-

mier coefficient ($a_1$), et

- des premiers moyens d'addition (98) auxquels sont appliqués le premier signal de variation ainsi obtenu comme un terme d'une somme, et, avec retardement d'un cycle, le contenu d'une troisième mémoire (102) comme l'autre terme de la somme,
- la sortie des premiers moyens d'addition (98) étant susceptible d'être lue dans la mémoire (102), et le contenu de la troisième mémoire (102) retardé d'un cycle formant le premier coefficient ($a_1$) du modèle, et
- des moyens (104) destinés à multiplier ledit premier coefficient ($a_1$) par le temps ($t_n$) du cycle respectif,

(c) des moyens (106) destinés à l'addition du coefficient zéro ($a_o$) et le premier coefficient ($a_1$) multiplié par le temps ($t_n$) du cycle afin de former une valeur estimative de la grandeur de mesure,

(d) ledit premier coefficient ($a_1$) fournissant une valeur estimative pour le signal utile constant.

5. Filtre selon la revendication 4, **caractérisé par le fait que** les moyens (74) destinés à former le signal de variation zéro et les moyens (96) destinés à former le premier signal de variation comprennent chacun des moyens (108,110) destinés à diviser la somme obtenue par les moyens d'addition (76,94) par la variance du bruit de mesure.

6. Filtre selon la revendication 4 ou 5, **caractérisé par le fait que**

(a) le premier canal (62) comprend en plus des moyens (122) destinés à multiplier la différence du signal de mesure intégré et la valeur estimative du signal de mesure intégré par un cinquième facteur ($P_{13;n}$) et le carré du temps ($t_n^2$) du cycle respectif, et le produit est également appliqué aux moyens (74) destinés à former un signal de variation représentant une variation du coefficient zéro ($a_o$),

(b) le second canal (84) comprend, en plus, des moyens (128) destinés à multiplier la différence entre le signal de mesure intégré et la valeur estimative du signal de mesure intégré par un sixième facteur ($P_{23;n}$) et le carré du temps ($t_n^2$) du cycle respectif, et le produit est également appliqué aux moyens (96) destinés à former un signal de variation représentant une variation du premier coefficient ($a_1$),

(c) l'estimateur optimal (54) comprend un troisième canal (134), avec

- des moyens (136) destinés à multiplier la différence entre le signal de mesure intégré et la valeur estimative du signal de mesure intégré par un septième facteur ($P_{33;n}$) variable en temps et le temps ($t_n^2$) du cycle respectif,
- des moyens (142) destinés à multiplier la différence entre le signal de mesure intégré et la valeur estimative du signal de mesure intégré par un huitième facteur ($P_{23;n}$) variable en temps et le carré du temps ($t_n^2$) du cycle respectif,
- des moyens (148) destinés à multiplier la différence entre le signal de mesure intégré et la valeur estimative du signal de mesure intégré par un neuvième facteur ($P_{13;n}$) variable en temps,
- des moyens (152) destinés à l'addition des trois produits ainsi obtenus et à la formation d'un second signal de variation représentant une variation d'un second coefficient ($a_2$),
- des seconds moyens d'addition (158) auxquels sont appliqués le second signal de variation ainsi obtenu comme un terme d'une somme, et, avec retardement d'un cycle, le contenu d'une quatrième mémoire (162) comme l'autre terme de la somme,
- la sortie des seconds moyens d'addition (158) étant susceptible d'être lue dans la mémoire (162), et le contenu de la quatrième mémoire (162) retardé d'un cycle formant le second coefficient ($a_2$) du modèle, et
- des moyens (164) destinés à multiplier ledit second coefficient ($a_2$) par le carré du temps ($t_n$) du cycle respectif.

7. Filtre selon la revendication 1, **caractérisé par le fait qu'**il est formé comme filtre Kalman, dans lequel

(a) la différence entre le signal de mesure intégré et la valeur estimative du signal de mesure intégré est multipliée par une première fonction ($K_1(t)$) variable en temps, et

(b) la différence entre le signal de mesure intégré et la valeur estimative du signal de mesure intégré est multipliée par une seconde fonction ($K_2(t)$) variable en temps et intégrée dans le temps par des premiers moyens d'intégration (172),

(c) les grandeurs ainsi formées sont additionnées par des moyens d'addition (174), et

(d) la somme ainsi formée est intégrée par des seconds moyens d'intégration (176) afin de former ladite valeur estimative du signal de mesure intégré,

(e) la sortie des premiers moyens d'intégration (172) fournissant la valeur estimative du signal utile.

Fig.1

$$z(t) = a_0 + a_1 \cdot t + v(t)$$

Fig.2

Fig.7

13

Fig.3

SIGNALPROZESS                    SIGNALVERARBEITUNG

Fig. 4

$m_n = [1 \ t_n \ t_n^2]$

$\circ$ —— 112

$\sigma_n$

$\circ$ —— 114

$$\frac{P_{n-1} \ \underline{m}_n^T \ \underline{m}_n \ P_{n-1}}{\underline{m}_n \ P_{n-1} \ \underline{m}_n^T + \sigma_n^2}$$

116

$$P_n = \begin{bmatrix} P_{11,n} & P_{12,n} \\ P_{21,n} & P_{22,n} \end{bmatrix}$$

$\circ \ P_0$

SPEICHER —— 118

$\boxed{\underset{T}{\llcorner\ulcorner}}$ —— 120

*Fig. 5*

EP 0 365 859 B1

*Fig. 6*

EP 0 365 859 B1

EP 0 365 859 B1

$$m_n = [1 \; t_n \; t_n^2]$$

112

$$o_n$$

114

116

$$\frac{P_{n-1} \; m_n^T \; m_n \; P_{n-1}}{\underline{m}_n \; P_{n-1} \; \underline{m}_n^T \; + \; o_n^2}$$

$$P_n = \begin{bmatrix} P_{11,n} & P_{12,n} & P_{13,n} \\ P_{21,n} & P_{22,n} & P_{23,n} \\ P_{31,n} & P_{32,n} & P_{33,n} \end{bmatrix}$$

$$P_0$$

SPEICHER 118

120

Fig.10

$$S(t_0)$$

$$w(t)$$

$$\int dt$$

$$y(t)$$

$$\int dt$$

$$z(t)$$

$$c_1 \cdot t \qquad c_0 \cdot \sin(\omega t + \varphi)$$

Fig.8

$$z(t) = a_0 + a_1 t + a_2 t^2 + v(t)$$

Fig.9